# FASCICULE DE BREVET EUROPEEN

(11) **EP 2 306 518 B1**
(45) Date de publication et mention de la délivrance du brevet: **31.12.2014**
(21) Numéro de dépôt: 10186459.3
(22) Date de dépôt: 04.10.2010
(51) Int. Cl.: H01L 23/58, H01L 21/265, H01L 21/322, H01L 27/02

(54) **Méthode de protection d'une puce de circuit intégré contre une analyse par attaques laser**
Methode zum Schutz eines Chips mit integrierter Schaltung vor Analyse durch Laserbestrahlung.
Method of protecting an integrated circuit chip against spying by laser attacks

(30) Priorité: 05.10.2009 FR 0956920; 05.10.2009 FR 0956923
(43) Date de publication de la demande: 06.04.2011
(73) Titulaire: STMicroelectronics (Rousset) SAS, 13790 Rousset (FR)
(72) Inventeur: Fornara, Pascal, 83910, POURRIERES (FR); Marinet, Fabrice, 13790, CHATEAUNEUF LE ROUGE (FR)
(74) Mandataire: Thibon, Laurent

(56) Documents cités:
- EP-A1- 1 691 413
- EP-A2- 1 508 917
- DE-A1- 10 337 256
- JP-A- 11 250 215
- US-A1- 2003 057 522
- US-B2- 6 919 618
- LEE D M ET AL: "IMPURITY GETTERING BY MISFIT DISLOCATIONS IN SI (2% GE) EPITAXY: NICKEL", APPLIED PHYSICS LETTERS, AIP, AMERICAN INSTITUTE OF PHYSICS, MELVILLE, NY, US, vol. 53, no. 5, 1 août 1988 (1988-08-01), pages 370-372, XP000020101, ISSN: 0003-6951, DOI: DOI:10.1063/1.99897
- BINNS M J: "EFFECTIVE INTRINSIC GETTERING FOR 200MM AND 300MM P/P-WAFERS IN A LOW THERMAL BUDGET 0.13 µm ADVANCED CMOS LOGIC PROCESS", 9TH INT. SYMP. SILICON MATERIALS SCIENCE & TECHNOLOGY, PHILADELPHIA, MAY 12-17, 2002, 17 mai 2002 (2002-05-17), XP002581984,
- KOVESHNIKOV SERGEI V ET AL: "Mechanism of iron gettering in MeV Si ion implanted epitaxial silicon", JOURNAL OF APPLIED PHYSICS, AMERICAN INSTITUTE OF PHYSICS. NEW YORK, US, vol. 84, no. 6, 15 septembre 1998 (1998-09-15), pages 3078-3084, XP012045855, ISSN: 0021-8979, DOI: DOI:10.1063/1.368462

## Description

### Domaine de l'invention

La présente invention concerne la protection d'une puce de circuit intégré contre des attaques laser.

### Exposé de l'art antérieur

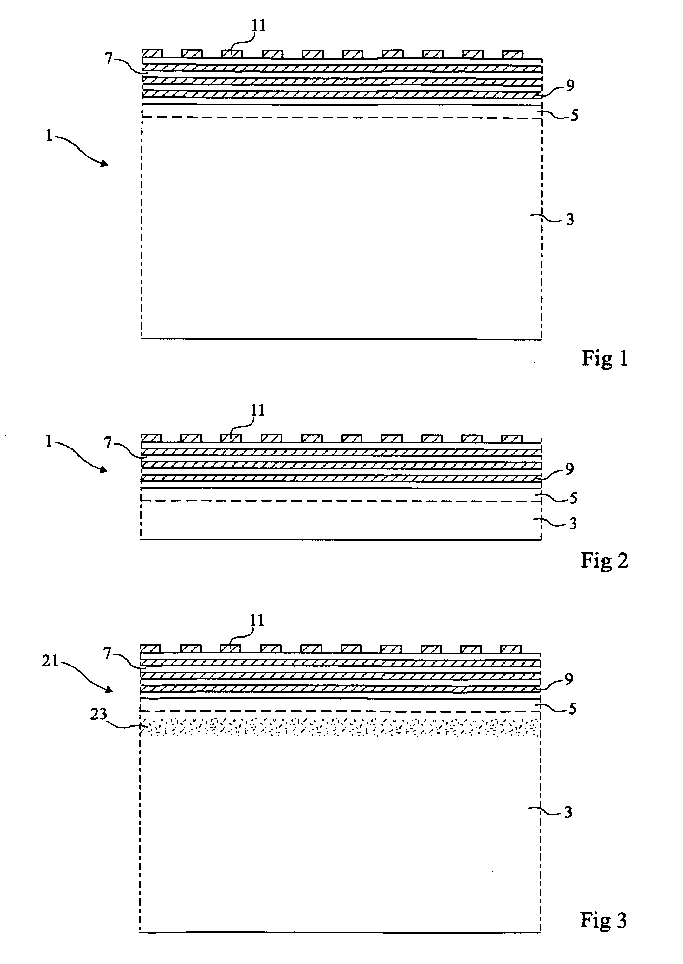

La figure 1 est une vue en coupe schématique d'une puce de circuit intégré 1 formée dans et sur un substrat semiconducteur 3. Le substrat 3 comprend dans sa partie supérieure une couche active 5, couramment une couche épitaxiée, dans laquelle sont réalisés des composants électroniques non représentés. De façon courante, la couche active 5 est recouverte d'un empilement de couches isolantes 7 et de pistes conductrices d'interconnexion 9. On prévoit généralement plusieurs niveaux d'interconnexion successifs. Des vias conducteurs non représentés traversent les couches isolantes pour relier les pistes conductrices entre elles, à des bornes 11 d'entrée-sortie de la puce, et à des composants de la couche active 5, réalisant ainsi les interconnexions du circuit.

Dans certains dispositifs, par exemple des composants sécurisés comme des cartes de paiement, des régions de la zone active 5 sont susceptibles de traiter et/ou de stocker des données sensibles, par exemple des clés de chiffrement. De tels dispositifs peuvent faire l'objet de manipulations frauduleuses visant à obtenir des informations confidentielles protégées.

Parmi les attaques connues, les attaques dites "attaques par faute", consistent à perturber volontairement le fonctionnement d'une puce, et à analyser l'influence des perturbations sur son comportement. L'attaquant s'intéresse notamment à l'influence des perturbations sur des données telles que des signaux de sortie, la consommation, ou des temps de réponse. Il est susceptible d'en déduire, par des études statistiques ou autres, des informations sensibles telles que les algorithmes utilisés et éventuellement des clés de chiffrement.

Pour provoquer volontairement des anomalies dans les circuits d'une puce, un mode d'attaque consiste à bombarder des zones localisées de la puce par un faisceau laser. On peut ainsi injecter des fautes dans certaines cellules mémoires et/ou affecter le comportement de certains composants. On notera que lors d'une attaque laser, la puce doit être alimentée.

En raison de la présence des pistes métalliques d'interconnexion du côté de la face avant du substrat, les attaques laser sont dans leur très grande majorité réalisées par la face arrière de la puce. En effet, du côté de la face avant, la probabilité pour un faisceau laser d'atteindre un composant à travers l'enchevêtrement de pistes métalliques est presque nulle. En outre, l'attaquant ne peut pas se permettre de retirer les niveaux d'interconnexion car cela rendrait la puce non opérationnelle et non analysable.

La figure 2 est une vue en coupe schématique de la puce 1 de la figure 1 illustrant une étape préliminaire d'amincissement du substrat 3, fréquemment mise en oeuvre avant une attaque laser par la face arrière. Une telle étape améliore l'efficacité de l'attaque laser en minimisant l'atténuation du faisceau par le substrat. Pour rendre accessible au faisceau laser les composants de la région active 5, l'attaquant doit retirer une partie de l'épaisseur du substrat 3 du côté de sa face inférieure ou face arrière. A titre d'exemple, une puce formée à partir d'un substrat de 180 µm d'épaisseur subira une diminution d'épaisseur de l'ordre de 130 µm avant une attaque laser.

Pour se prémunir contre les fraudes, il est généralement prévu dans les puces sécurisées un dispositif de détection d'attaque, couplé à un circuit de protection. Lorsqu'une attaque est détectée, le circuit de protection met en oeuvre des mesures de protection, d'aliénation, ou de destruction des données sensibles. Par exemple, on pourra prévoir, lorsqu'une attaque est détectée, d'interrompre l'alimentation de la puce ou de provoquer sa réinitialisation, de façon à minimiser le temps pendant lequel l'attaquant peut étudier la réponse de la puce à une perturbation.

Les solutions de détection d'attaque peuvent être logiques. Elles consistent par exemple à introduire régulièrement dans les calculs des tests d'intégrité permettant de s'assurer que des données ne sont pas en cours de modification. Ces solutions présentent l'inconvénient d'introduire des étapes de calcul supplémentaires, augmentant ainsi les temps de réponse de la puce. En outre, les tests d'intégrité ne peuvent pas détecter toutes les perturbations provoquées par un attaquant. Ce dernier dispose donc d'une certaine marge de manoeuvre susceptible de lui permettre d'acquérir des informations sensibles.

D'autres solutions de détection d'attaque, dites physiques, comportent notamment des capteurs sensibles aux variations de température, aux ultraviolets, ou aux rayons X, permettant de déceler des activités suspectes. De même que les solutions logiques, ces solutions ne sont pas parfaitement fiables. En effet, avant la détection de l'attaque, l'attaquant dispose d'une marge de manoeuvre susceptible de lui permettre d'obtenir des informations sensibles. De plus, la mise en oeuvre de ces solutions est complexe et augmente la surface de silicium nécessaire à la réalisation de la puce.

La publication "Impurity gettering by misfit dislocations in Si (2%Ge) epitaxy : nickel", de Lee D M et al - Applied Physics Letters, AIP, American Institute of Physics, Melville, NY, US, vol.53, no.5, 1er aout 1988, pages 370-372, XP000020101, ISSN : 0003-6951, DOI:DOI:10.1063/1.99897, décrit la formation de zones de piégeage d'impuretés métalliques, sous une couche de silicium formée par épitaxie à la surface d'un substrat de silicium.

Par ailleurs, les documents EP1508917 A2 (notamment la figure 16 et les paragraphes [0056] et [0057]), JP11250215 A (notamment l'abstract) et DE10337256 A1 (notamment la figure 1 et le paragraphe [0032]), décrivent diverses solutions de protection d'une puce de circuit intégré contre des attaques en face arrière.

### Résumé

Un objet d'un mode de réalisation de la présente invention est de prévoir un système de protection d'une puce de circuit intégré contre des attaques laser palliant au moins certains des inconvénients des solutions de l'art antérieur.

Un objet d'un mode de réalisation de la présente invention est de prévoir un tel système renforçant ou éven-tuellement remplaçant les solutions de l'art antérieur.

Un objet d'un mode de réalisation de la présente invention est de prévoir un tel système permettant d'empêcher l'attaquant d'obtenir des informations sensibles avant que l'attaque ne soit détectée par des moyens usuels.

Ainsi, un mode de réalisation de la présente invention prévoit, selon la revendication 1, un procédé de protection contre des attaques laser d'une puce de circuit intégré formée dans et sur un substrat semiconducteur et comprenant dans la partie supérieure du substrat une partie active dans laquelle sont formés des composants, ce procédé comportant les étapes suivantes : former dans le substrat une zone de piégeage d'impuretés s'étendant sous la partie active, la limite supérieure de ladite zone étant à une profondeur comprise entre 5 et 50 µm de la face supérieure du substrat ; et introduire dans le substrat des impuretés métalliques diffusantes adaptées à être retenues dans la zone de piégeage à une concentration comprise entre 10¹⁷ et 10¹⁸ atomes par cm³, les impuretés métalliques étant des atomes de fer et la concentration finale d'atomes de fer dans la zone de piégeage étant comprise entre 10¹⁷ et 10¹⁸ atomes par cm³.

Les revendications dépendantes définissent des modes de réalisation privilégiés de l'invention. Selon un mode de réalisation de la présente invention, la formation des sites de piégeage comprend une étape d'implantation profonde d'un gaz rare dans le substrat, suivie d'une étape de recuit.

Selon un mode de réalisation de la présente invention, le gaz rare est de l'hélium.

Selon un mode de réalisation de la présente invention, la zone de piégeage d'impuretés s'étend sur une épaisseur comprise entre 0,5 µm et 5 µm.

Selon un mode de réalisation de la présente invention, les sites de piégeage sont formés par précipitation d'oxygène.

Selon un mode de réalisation de la présente invention, la zone de piégeage d'impuretés s'étend jusqu'à la face arrière du substrat.

Selon un mode de réalisation de la présente invention, le procédé comprend une étape d'implantation d'atomes de fer dans le substrat.

Un autre mode de réalisation de la présente invention prévoit ,selon la revendication 8, une puce de circuit intégré formée dans et sur un substrat semiconducteur et comprenant : dans la partie supérieure du substrat, une partie active dans laquelle sont formés des composants ; et sous la partie active et à une profondeur comprise entre 5 et 50 µm de la face supérieure du substrat, une zone comprenant des sites de piégeage de fer et contenant des atomes de fer à une concentration comprise entre 10¹⁷ et 10¹⁸ atomes/cm³.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue en coupe schématique d'une portion d'une puce de circuit intégré ;
la figure 2, précédemment décrite, est une vue en coupe schématique de la portion de puce de la figure 1 après amincissement de son substrat ;
la figure 3 est une vue en coupe représentant de façon schématique un exemple de réalisation d'une puce de circuit intégré munie d'un système de protection contre des attaques laser ; et
la figure 4 est une vue en coupe représentant de façon schématique une variante de réalisation d'une puce de circuit intégré munie d'un système de protection contre des attaques laser.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Un aspect d'un mode de réalisation de la présente invention est de prévoir, dans le substrat, une couche de protection adaptée à atténuer et à disperser un éventuel faisceau laser d'attaque de façon à élargir le faisceau et à l'empêcher d'atteindre une zone précise de la partie active. De plus, en chaque point de la puce, la puissance laser sera réduite.

La figure 3 est une vue en coupe représentant de façon schématique un exemple de réalisation d'une puce de circuit intégré 21 munie d'un système de protection contre les attaques laser. Comme la puce 1 décrite en relation avec la figure 2, la puce 21 est formée dans et sur un substrat 3. Le substrat 3 comprend, sous une partie active 5 dans laquelle sont formés les composants de la puce, une zone 23 adaptée à disperser un faisceau laser.

Dans la zone 23, on a formé des sites de piégeage adaptés à retenir des impuretés métalliques. La zone 23 comprend une forte concentration d'impuretés métalliques introduites intentionnellement, les impurités métalliques étant des atomes de fer.

La prévision de zones de piégeage dans un substrat semiconducteur a été proposée pour débarrasser les régions actives du substrat d'impuretés indésirables susceptibles de dégrader les performances de certains composants. Ces zones de piégeage ont pour rôle de retenir d'éventuelles impuretés parasites introduites dans le substrat pendant la fabrication, de façon que ces impuretés ne viennent pas contaminer des régions actives du substrat. On utilise de telles techniques notamment dans le domaine des dispositifs à semiconducteurs de puissance.

Un exemple de procédé de réalisation d'une zone de piégeage consiste à prévoir, dans une région localisée du substrat, une implantation à haute dose d'un gaz rare tel que l'hélium, l'argon ou le xénon. Un recuit consécutif adapté entraîne la formation de bulles et/ou de dislocations dans cette région. Les défauts ainsi formés se trouvent être des sites de piégeage adaptés à retenir d'éventuelles impuretés métalliques présentes dans le substrat.

Après avoir formé la zone de piégeage 23, par exemple selon le procédé susmentionné, on prévoit de contaminer intentionnellement le substrat, par exemple par implantation d'atomes de fer. Les impuretés ainsi introduites viennent se concentrer dans la zone 23 et y sont retenues. Ces impuretés permettent de diffracter/disperser/atténuer un éventuel faisceau laser d'attaque, faisant ainsi écran aux composants de la puce 21.

La zone de piégeage contaminée 23 doit être placée à une distance de la couche active 5 suffisamment faible pour que, lors de l'étape préalable d'amincissement, l'attaquant ne puisse pas la retirer sans endommager la puce. De façon courante, la couche active 5 dans laquelle sont formés les composants de la puce a une épaisseur de l'ordre de 3 µm à 10 µm. Après amincissement selon les techniques habituelles, le substrat 3 a une épaisseur de l'ordre de 50 µm. Un amincissement plus important risquerait d'entraîner un déséquilibre des contraintes mécaniques s'exerçant dans la puce. Notamment, les pistes et vias d'interconnexion risqueraient de se rompre, rendant la puce inutilisable.

Ainsi, à titre d'exemple, la zone de piégeage contaminée 23 pourra donc avoir une épaisseur de l'ordre de 0,5 µm à 5 µm et être formée, sous la couche active 5, à une distance comprise entre 12 µm et 20 µm de la face supérieure du substrat 3. Toutefois, l'invention ne se restreint pas à ce cas particulier. On pourra par exemple prévoir une zone de piégeage s'étendant sur presque toute l'épaisseur du substrat 3, depuis sa face arrière jusqu'à une distance de quelques µm, par exemple de l'ordre de 5 µm à 20 µm, de la couche active 5.

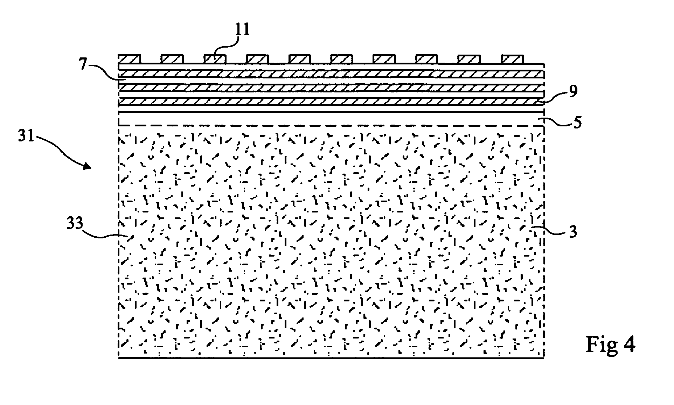

La figure 4 est une vue en coupe représentant de façon schématique une variante de réalisation d'une puce de circuit intégré 31 munie d'un système de protection contre des attaques laser. Dans cet exemple, par comparaison avec la puce 21 décrite en relation avec la figure 3, la zone mince de piégeage contaminée 23 a été remplacée par une zone de piégeage étendue 33. La zone de piégeage 33 s'étend depuis la face arrière du substrat jusqu'à une distance de l'ordre de 5 µm à 20 µm, de la couche active 5.

On pourra par exemple fabriquer la puce 31 dans et sur une tranche de silicium formée selon la technologie "MDZ®", de l'anglais "Magic Denuded Zone". De telles tranches sont notamment décrites dans l'article "Effective intrinsic gettering for 200 mm and 300 mm P/P-wafers in a low thermal budget 0,13 µm advanced CMOS logic process", de M.J. Binns, présenté en 2002 à la conférence "9th Int. Symp. Silicon Materials Science & Technology, Philadelphia, Mai 12-17, 2002", et disponible sur le site internet "http://www.memc.com/". Une telle tranche comprend en effet, dans le substrat, des sites de piégeage préalablement formés par précipitation d'oxygène. Ces sites sont répartis dans une grande partie de l'épaisseur du substrat, depuis la face arrière jusqu'à quelques dizaines de µm de la face avant. Ces sites sont adaptés à concentrer et à retenir d'éventuelles impuretés métalliques.

On prévoit alors une étape de contamination intentionnelle du substrat, par exemple par implantation d'atomes de fer, tel que décrit ci-dessus.

La concentration d'impuretés métalliques dans la zone 23 (figure 3) ou 33 (figure 4) sera de préférence choisie élevée. Cette concentration dépend notamment du procédé de formation de la couche de piégeage ainsi que du procédé utilisé pour introduire les impuretés métalliques dans cette couche. A titre d'exemple, dans le cas d'une zone de piégeage mince telle que la zone 23 de la figure 3, on pourra former des sites de piégeage par implantation d'hélium à 40 keV et 5x10¹⁶ atomes/cm², suivie d'un recuit adapté. On pourra consécutivement mettre en oeuvre une étape d'implantation d'atomes de fer par la face arrière du substrat, à 100 keV et 10¹² atomes/cm², jusqu'à obtenir une concentration finale d'atomes de fer dans la zone 23 de l'ordre de 10¹⁷ à 10¹⁸ atomes/cm³.

Un avantage du système de protection proposé est qu'il oblige l'attaquant à augmenter considérablement, par exemple d'un facteur de l'ordre de 10 à 100, la puissance du faisceau laser pour pouvoir injecter des fautes dans les circuits de la puce. Par conséquent, avant que l'attaquant ne puisse acquérir des informations sensibles, l'attaque sera facilement détectée par des moyens classiques, par exemple des détecteurs de variation de température.

De plus, la présence de la zone de piégeage contaminée rend difficile pour l'attaquant de contrôler la taille et la position du faisceau laser au niveau de la couche active de la puce.

Un autre avantage du système de protection proposé est qu'il ne nécessite pas de modification des circuits de la puce que l'on souhaite protéger, ni de modification du procédé de fabrication. De plus, les étapes de fabrication nécessaires à la formation de la zone de piégeage contaminée sont compatibles avec les procédés de fabrication usuels d'une puce de circuit intégré. Le système proposé peut donc être employé pour protéger facilement et à moindre coût tout type de circuit. En outre, un tel système de protection n'augmente pas la surface de silicium nécessaire à la réalisation de la puce.

Des modes de réalisation particuliers de la présente invention ont été décrits. Diverses variantes et modifications apparaîtront à l'homme de l'art.

En particulier, les épaisseurs mentionnées ci-dessus pour les différentes couches d'une puce de circuit intégré et notamment pour la couche de piégeage sont données uniquement à titre d'exemple. L'homme de l'art saura mettre en oeuvre le fonctionnement recherché en utilisant des épaisseurs différentes.

Par ailleurs, on a mentionné ci-dessus diverses techniques de formation de zones de piégeage adaptées à concentrer et à retenir des impuretés métalliques introduites dans un substrat semiconducteur. L'invention ne se restreint pas à ces exemples particuliers. L'homme de l'art saura mettre en oeuvre le fonctionnement recherché quel que soit le procédé employé pour former la zone de piégeage.

De même, on a proposé de contaminer intentionnellement le substrat, après formation de la zone de piégeage, par implantation d'atomes de fer. L'homme de l'art saura mettre en oeuvre le fonctionnement recherché quel que soit le procédé employé pour introduire des atomes de fer à la concentration souhaitée dans la zone de piégeage.

On a décrit ci-dessus un système de protection d'une puce de circuit intégré contre des attaques laser, ce système comprenant une zone de piégeage dans laquelle on a introduit intentionnellement des atomes de fer. Toutefois, on pourra prévoir d'autres applications à la prévision d'une telle zone de piégeage contaminée. Ainsi, la présente invention vise une puce de circuit intégré comprenant une zone de piégeage, s'étendant sous la partie active de la puce, à faible distance de la partie active, et comprenant une forte concentration d'atomes de fer.

## Revendications

1. Procédé de protection contre des attaques laser d'une puce de circuit intégré (21 ; 31) formée dans et sur un substrat semiconducteur (3) et comprenant dans la partie supérieure du substrat une partie active (5) dans laquelle sont formés des composants, ce procédé comportant les étapes suivantes :
former dans le substrat une zone (23 ; 33) de piégeage d'impuretés s'étendant sous la partie active (5), la limite supérieure de ladite zone étant à une profondeur comprise entre 5 et 50 µm de la face supérieure du substrat ; et
introduire dans le substrat des impuretés métalliques diffusantes adaptées à être retenues dans la zone de piégeage à une concentration comprise entre 10¹⁷ et 10¹⁸ atomes par cm³,
les impuretés métalliques étant des atomes de fer et la concentration finale d'atomes de fer dans la zone de piégeage étant comprise entre 10¹⁷ et 10¹⁸ atomes par cm³.

2. Procédé selon la revendication 1, dans lequel la formation des sites de piégeage comprend une étape d'implantation profonde d'un gaz rare dans le substrat, suivie d'une étape de recuit.

3. Procédé selon la revendication 2, dans lequel le gaz rare est de l'hélium.

4. Procédé selon la revendication 2 ou 3, dans lequel ladite zone (23) s'étend sur une épaisseur comprise entre 0,5 µm et 5 µm.

5. Procédé selon la revendication 1, dans lequel les sites de piégeage sont formés par précipitation d'oxygène.

6. Procédé selon la revendication 5, dans lequel ladite zone (33) s'étend jusqu'à la face arrière du substrat.

7. Procédé selon l'une quelconque des revendications 1 à 6, comprenant une étape d'implantation d'atomes de fer dans le substrat.

8. Puce de circuit intégré (21 ; 31) formée dans et sur un substrat semiconducteur (3) et comprenant :
dans la partie supérieure du substrat, une partie active (5) dans laquelle sont formés des composants ; et
sous la partie active (5) et à une profondeur comprise entre 5 et 50 µm de la face supérieure du substrat, une zone comprenant des sites de piégeage de métal et contenant des atomes de fer à une concentration comprise entre 10¹⁷ et 10¹⁸ atomes/cm³.

## Patentansprüche

1. Ein Verfahren zum Schutz eines integrierten Schaltkreis-Chips (21; 31) vor Laserattacken, der in- und auf einem Halbleitersubstrat (3) ausgebildet ist und wobei der integrierte Schaltkreis in einem oberen Teil des Substrats einen aktiven Teil (5) aufweist, in dem Komponenten ausgebildet sind, wobei das Verfahren die folgenden Schritte aufweist:
Ausbilden einer Getterzone (23; 33) die sich unter dem aktiven Teil (5) erstreckt, wobei die obere Grenze der Zone in einer Tiefe in einem Bereich von 5 bis 50 µm von der Oberfläche des Substrats angeordnet ist; und
Einbringen von diffundierenden Metallverunreinigungen in das Substrat, wobei die Metallverunreinigungen geeignet sind in der Getterzone mit einer Konzentration im Bereich von 10¹⁷ bis 10¹⁸ Atome/cm³ zurückgehalten zu werden, wobei die Metallverunreinigungen Eisenatome sind und wobei die Endkonzentration der Eisenatome in der Getterzone im Bereich von 10¹⁷ bis 10¹⁸ Atome/cm³ liegt.

2. Das Verfahren nach Anspruch 1, wobei das Ausbilden der Gettergebiete einen Schritt des Tiefimplantierens eines Edelgases in das Substrat aufweist, gefolgt von einem Annealschritt.

3. Das Verfahren nach Anspruch 2, wobei das Edelgas Helium ist.

4. Das Verfahren nach Anspruch 2 oder 3, wobei sich die Zone (23) über eine Dicke im Bereich von 0,5 µm bis 5µm erstreckt.

5. Das Verfahren nach Anspruch 1, wobei die Gettergebiete durch Ausfällung von Sauerstoff erzeugt werden.

6. Das Verfahren nach Anspruch 5, wobei sich die Zone (33) bis zur Rückseite des Substrates erstreckt.

7. Das Verfahren nach einem der Ansprüche 1 bis 6, wobei das Verfahren ferner einen Schritt zum Implantieren von Eisenatomen in das Substrat aufweist.

8. Ein integrierter Schaltkreis-Chip (21; 31), wobei der Chip in- und auf einem Halbleitersubstrat (3) ausgebildet ist und Folgendes aufweist:
in dem oberen Teil des Substrats, einen aktiven Teil (5) in dem Komponenten ausgebildet sind; und
unter dem aktiven Teil (5) und in einer Tiefe im Bereich von 5 bis 50 µm von der Oberfläche des Substrats, eine Zone, die Gebiete zum Gettern von Metallverunreinigungen aufweist und zum Aufnehmen von Eisenatomen mit einer Konzentration im Bereich von 10¹⁷ bis 10¹⁸ Atome/cm³.

## Claims

1. A method for protecting against laser attacks an integrated circuit chip (21; 31) formed inside and on top of a semiconductor substrate (3) and comprising in the upper portion of the substrate an active portion (5) in which components are formed, this method comprising the steps of:
forming in the substrate a gettering area (23; 33) extending under the active portion (5), the upper limit of said area being at a depth ranging between 5 and 50 µm from the upper surface of the substrate; and
introducing diffusing metal impurities into the substrate, the metal impurities being adapted to be retained in the gettering area at a concentration ranging between 10¹⁷ and 10¹⁸ atoms/cm³, the metal impurities being iron atoms and the final concentration of iron atoms in the gettering area ranging between 10¹⁷ and 10¹⁸ atoms/cm³.

2. The method of claim 1, wherein the forming of the gettering sites comprises a step of deep implantation of a rare gas into the substrate, followed by an anneal step.

3. The method of claim 2, wherein the rare gas is helium.

4. The method of claim 2 or 3, wherein said area (23) extends across a thickness ranging between 0.5 µm and 5 µm.

5. The method of claim 1, wherein the gettering sites are formed by precipitation of oxygen.

6. The method of claim 5, wherein said area (33) extends all the way to the rear surface of the substrate.

7. The method of any of claims 1 to 6, comprising a step of implantation of iron atoms in the substrate.

8. An integrated circuit chip (21; 31) formed inside and on top of a semiconductor substrate (3) and comprising:
in the upper portion of the substrate, an active portion (5) in which components are formed; and
under the active portion (5) and at a depth ranging between 5 and 50 µm from the upper surface of the substrate, an area comprising sites for gettering metal impurities and containing iron atoms at a concentration ranging between 10¹⁷ and 10¹⁸ atoms/cm³.
